# EUROPEAN PATENT APPLICATION

(11) **EP 2 521 181 A1**
(43) Date of publication of application: **07.11.2012**
(21) Application number: 11425123.4
(22) Date of filing: 04.05.2011
(51) Int. Cl.: H01L 31/02, H01L 31/048

(54) **Photovoltaic covering**

(71) Applicant: MX Group S.p.A., 20058 Villasanta (Monza Brianza) (IT)
(72) Inventor: Margadonna, Daniele, 00043 Ciampino (Roma) (IT); Clemente, Raffaele, 208347 Nova Milanese (Monza Brianza) (IT)
(74) Representative: Tirloni, Bartolomeo

(57) **Abstract**

A photovoltaic coating comprises at least two photovoltaic panels (2), at least two junction boxes (3) connected to the panels (2) and to a board (4) for conversion of the produced electric energy, spacer elements (12) for creating an air space for air recirculation (13) between the photovoltaic panels (2) and roof frame elements. The coating (1) comprises at least one conveying drain (14) inside the air-recirculation space (13) disposed under the panels for conveying rain water; a detecting device for temperature detection, acting on a respective junction box (3) for generating a signal (ST) representative of the temperature in the junction box (3); a breaking device (7) acting in the junction box (3) for electrically insulating it from the conversion board (4) on receipt of a break signal (SI) generated by a comparing device (6) when the temperature signal (ST) exceeds the threshold value (SV).

## Description

The present invention relates to a photovoltaic coating, i.e. a cover (such as a roof or a portion thereof, a façade or a portion thereof, for example) of buildings adapted to protect the building interior from atmospheric agents and capable of converting the sun radiation into electric energy using photovoltaic modules specifically developed for being integrated with and replacing architectonic elements.

In the following, reference will be explicitly made to photovoltaic roofs when dealing with the above mentioned photovoltaic coatings.

Photovoltaic coatings are distinguishable from photovoltaic panels installed on the building roofs as they not only act as electric energy generators but also cover the building itself.

The photovoltaic roofs of the known art consist of one or more photovoltaic modules secured to the structural elements of the building roof, the roof frame beams for example.

The photovoltaic modules are electrically connected with each other in such a manner that the electric energy produced by each photovoltaic module is conveyed to a general board and then converted from direct current to alternating current to be delivered to the electric network or mains.

In particular, each photovoltaic module is provided with output terminals placed in a junction box. Two adjacent modules are therefore electrically connected to each other at the inside of the junction box.

To prevent the junction box from being directly exposed to the atmospheric agents, said box is disposed under the photovoltaic modules, i.e. within a hollow spaced formed between the photovoltaic modules and the heat insulating material of the roof that is required for limiting heat exchange between the building exterior and interior.

It should be noted that this hollow space is made necessary for enabling the roof to be "ventilated" because the assurance of a good ventilation is required in the part underlying the module in order to prevent the work temperature of the module from growing too much. In fact, as known, photovoltaic modules convert about 15% of the incident sun radiation into electric energy.

The unconverted radiation is partly reflected by the module surface and mostly converted into heat that will raise the module temperature.

The hollow space mentioned above usually has a thickness of about 10 cm, as required to ensure air circulation, which air entering the gutter gets warm and then goes up along the pitch for at last going out of the coating ridge (thus removing hot air from the hollow space).

In this way, the temperature of the air in the hollow space remains confined within the Normal Operating Cell Temperature (NOCT) of the module, which temperature generally ranges between 40 and 50°C.

The junction box of the modules and the energy-carrying cables are usually in contact with, or in the vicinity of, the wooden grid of the roof frame and the insulating material.

It is apparent from the above that the risks of fire in photovoltaic roofs are rather high. In fact, there is the simultaneous potential presence of the three elements necessary for fire generation, i.e. the combustible substance (the insulating material of the roof and the supporting roof frame often made of wood), the comburent (the oxygen present in the hollow space that is continually renewed by the convective current created between the gutter and the roof ridge) and the triggering temperature (possible sparks or voltaic arcs produced in the junction boxes placed in the hollow space).

In addition, in case of fire, the work of the fire brigade is full of problems because the photovoltaic installation remains alive even if the general electric board is disconnected (the photovoltaic modules go on producing electric current and transmitting it to the electric board) .

In this context, the technical task underlying the present invention is to make available a photovoltaic coating free from the above mentioned drawbacks.

In particular, the present invention aims at providing a photovoltaic coating reducing the risks of fire.

Another aim of the invention is to provide a photovoltaic coating enabling easy intervention by the fire brigade if a fire is generated.

Further features and advantages will become more apparent from the detailed description of a preferred but not exclusive embodiment of a photovoltaic coating according to the invention.

This description is taken with reference to the accompanying drawings, given by way of non-limiting example, in which:
- Fig. 1 is a functional diagram of a photovoltaic coating in accordance with the present invention;
- Fig. 2 is a further functional diagram of the photovoltaic coating seen in Fig. 1;
- Fig. 3 is a section view taken along a pitch line of a photovoltaic coating in accordance with the present invention in which the coating is a roof; and
- Fig. 4 is a section perpendicular to a pitch line of the coating in Fig. 4.

With reference to the accompanying drawings, a photovoltaic coating in accordance with the present invention has been generally denoted at 1.

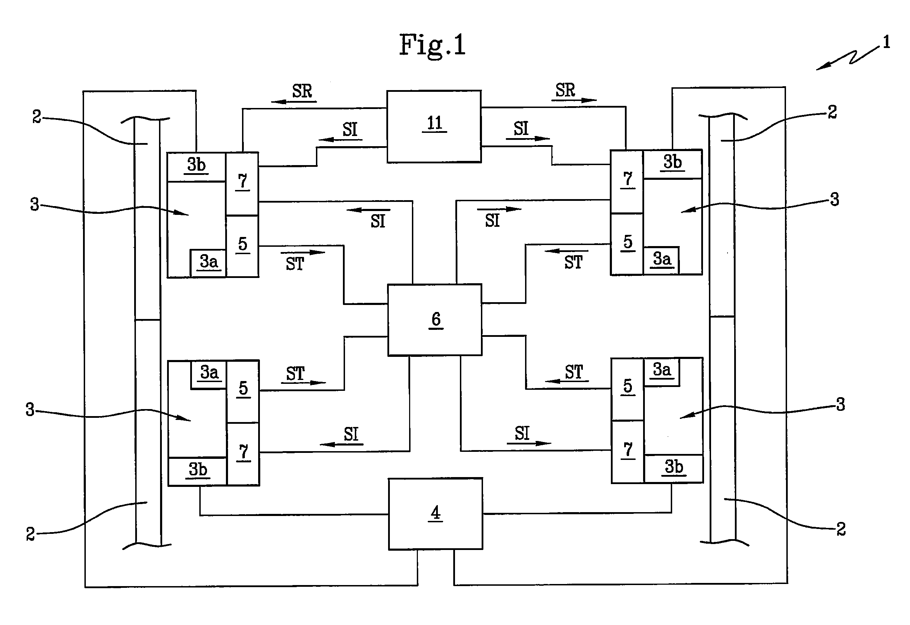

Coating 1 comprises at least two photovoltaic panels 2 (three photovoltaic panels are diagrammatically shown in Fig. 1) adjacent to each other.

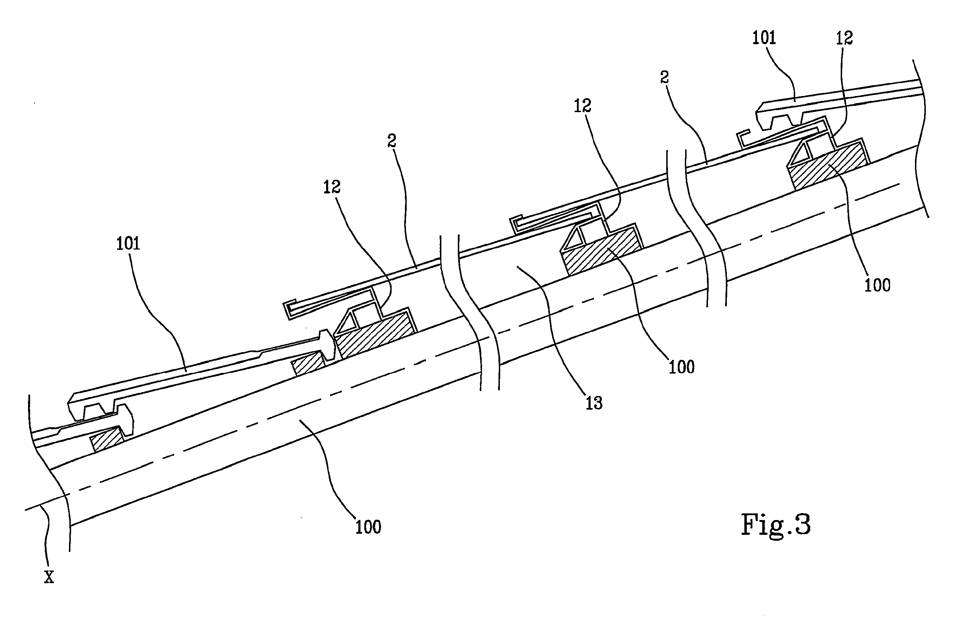

As shown in section in Fig. 3, panels 2 are disposed in a mutually approached position along an approach line X.

Coating 1 further comprises at least two junction boxes 3, and in particular comprises at least one junction box 3 for each panel 2 (three junction boxes 3 are shown in Fig. 1).

The function of the junction box 3 is to contain the electric terminals of the panel circuitry through which the electric energy produced by the panel is collected.

The electric energy produced by the photovoltaic panel 2 reaches input terminals 3a of the junction box 3 that, through output terminals 3b of its own, is in electrical connection with a conversion board 4.

In the conversion board 4 the energy produced by panels 2 is first converted from direct current into alternating current and then delivered to the mains, through suitable and known electric and electronic devices.

Therefore, all junction boxes 3 are connected to the conversion board 4 (see Fig. 1 for example). In addition, all junction boxes 3 may be all electrically connected to each other, or only some of them may be electrically connected to each other (as shown in Fig. 1.

Coating 1 comprises a temperature detecting device 5 acting on each junction box 3 for generating a plurality of signals ST representative of the temperature in each junction box 3.

Preferably, as diagrammatically shown in Fig. 1, the detecting device is housed inside the junction box 3. In particular, each junction box 3 is provided with a respective detecting device 5.

In the preferred embodiment of the invention, the detecting device 5 is a temperature sensor consisting of a thermocouple or a thermoresistor that is able to detect the temperature inside the junction box 3.

A comparing device 6 receives the temperature signals ST and compares them with a threshold value SV. The comparing device 6 generates a break signal SI when a temperature signal exceeds the threshold value SV.

In particular, the comparing device 6 generates the break signal SI when a predetermined number of consecutive temperature signals ST generated by a detecting device 5 exceeds the threshold value SV. Preferably, the aforesaid consecutive signals are five in number.

Alternatively, the comparing device 6 generates the break signal SI when all temperature signals ST generated by a detecting device 5 and sent within a time unit exceed the threshold value SV. Preferably the aforesaid time unit is three minutes.

The temperature signals that, exceeding the threshold value, give rise to generation of the break signal, all come from the same junction box 3, so that the junction box suffering an anomalous temperature can be localised.

The threshold signal SV is about 2-2.5 times the NOCT of the module, i.e. the normal operating cell temperature that is generally in the range of 40 to 50°C.

The threshold signal SV is included between 90°C and 115°C and is preferably equal to 105°C.

In this manner it is possible to identify an anomalous temperature within one or more junction boxes 3, which temperature is indicative either of an incorrect fastening of the terminal board of the panel to the input terminals 3a of the junction box (giving rise to a voltaic arc between the alive parts) or of overheating of the environment external to the panel, most likely due to generation of flames.

The break signal SI generated by the comparing device 6 is sent to a breaking device 7 acting in each junction box 3 for electrically insulating said box from the conversion board 4.

In this manner, when an anomalous temperature in a junction box 3 is detected, this junction box and the photovoltaic panel 2 connected thereto are electrically insulated from the rest of the photovoltaic coating, thus preventing generation of a fire (should the anomalous temperature be generated by a photovoltaic arc) or enabling an immediate intervention aiming at limiting propagation of the flames (since the panel concerned with fire generation is made safe from the electrical point of view).

In particular, the breaking device 7 shortcircuits the output terminals 3b of the junction box 3 when a break signal SI generated by the comparing device 6 is received, when the temperature signal ST emitted by the detecting device 5 associated with the same junction box 3 exceeds the threshold value SV.

Alternatively, the breaking device 7 shortcircuits the output terminals 3b of the junction boxes 3 on receipt of a break signal SI generated by the comparing device 6 when the temperature signal emitted by the detecting device 5 associated with anyone of the junction boxes exceeds the threshold value SV. In this manner, irrespective of the junction box 3 in which an anomalous temperature has occurred, all junction boxes 3 are electrically insulated.

Preferably, the breaking device 7 is a relay acting on the output terminals 3b of the junction box 3. In particular, the relay placed in the junction box 3 is in the normally-open condition during normal operation of coating 1 and triggers to the closed-contact position on receipt of the break signal. In this configuration (closed contact) the electric energy generated by the photovoltaic panel is not sent to the conversion board and only serves to keep the relay in the closed position.

Preferably, the comparing device 6 receives signals from the detecting devices 5 and sends signals to the breaking devices 7 through wireless technology.

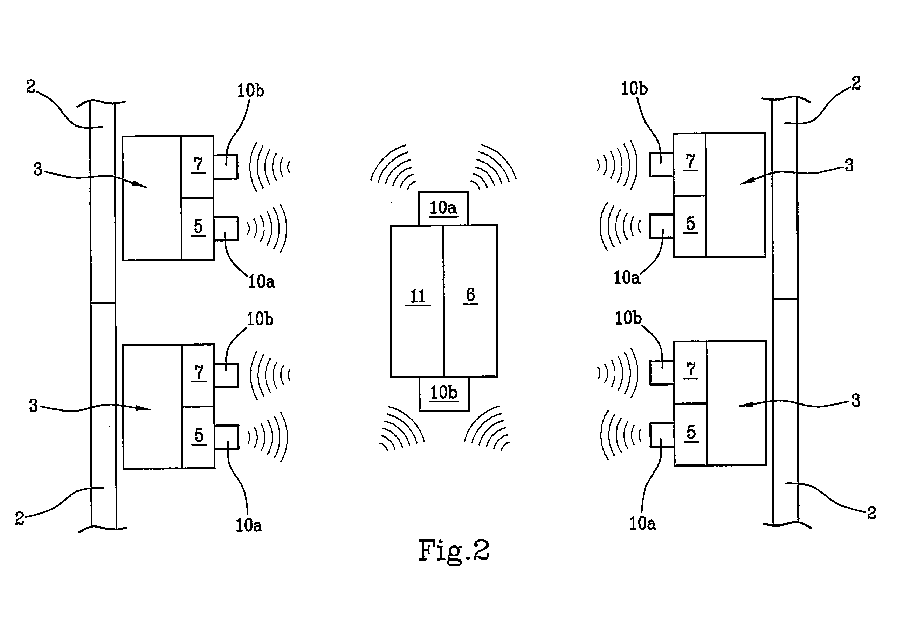

To this aim, the detecting devices 5 and breaking devices 7 are provided with wireless transmitters 10a and wireless receivers 10b respectively, and the comparing device is equipped both with the wireless transmitter 10a and the wireless receiver 10b (see diagram in Fig. 2).

Coating 1 further comprises a user-recognising unit 11 for recognising authorised users (Fig. 1).

The recognising unit 11 is configured for enabling an authorised user to generate break signals SI for the breaking devices 7, irrespective of receiving of temperature signals ST from the comparing device 6. In this manner, each photovoltaic panel 2 and the related junction box 3 can be electrically insulated from the conversion board 4 manually, i.e. by an authorised user that, according to his/her choice and in an independent manner, identifies a danger situation.

The recognising unit 11 further generates a refit signal SR and sends it to one or more breaking devices 7 for refitting one or more junction boxes 3 that have received break signals SI.

This refit signal is generated by an authorised user (note that in Fig. 1 the recognising unit 11 has been shown, for convenience, only active on two junction boxes 3 even if, as above said, it is active on all junction boxes 3).

Preferably, the user recognising unit 11 is provided with a chip card reader for recognising the user.

The user recognising unit 11 too sends signals to the breaking devices 7 through wireless technology. Therefore, the user-recognising unit 11 too is provided with the wireless receiver 10b and the wireless transmitter 10a (see Fig. 2).

Preferably, the comparing device 6, conversion board 4 and user-recognising unit 11 are physically housed in a single container placed at a remote position relative to panels 2.

Note that also the mounting structure of coating 1 cooperates with the described measures for inhibiting fire propagation.

In fact, coating 1 comprises spacer elements 12 acting between the photovoltaic panels 2 and roof frame elements 100 of a coating (intended as structural portion of a roof or a building façade), for creating an air space for air recirculation 13 between the photovoltaic panels 2 and the roof frame elements 100 (Fig. 3) .

Coating 1 further comprises at least one conveying drain 14 acting within the air space 13 and disposed under the approach line X for conveying rain water to a gutter. In this way, possible water seepage, that is clearly very dangerous when alive devices are present, is collected and evacuated in a controlled manner, thus reducing possible shortcircuits that could start a fire.

To this aim it is also to be noted that the conveying drain 14 is made of a metal (and therefore uninflammable) material.

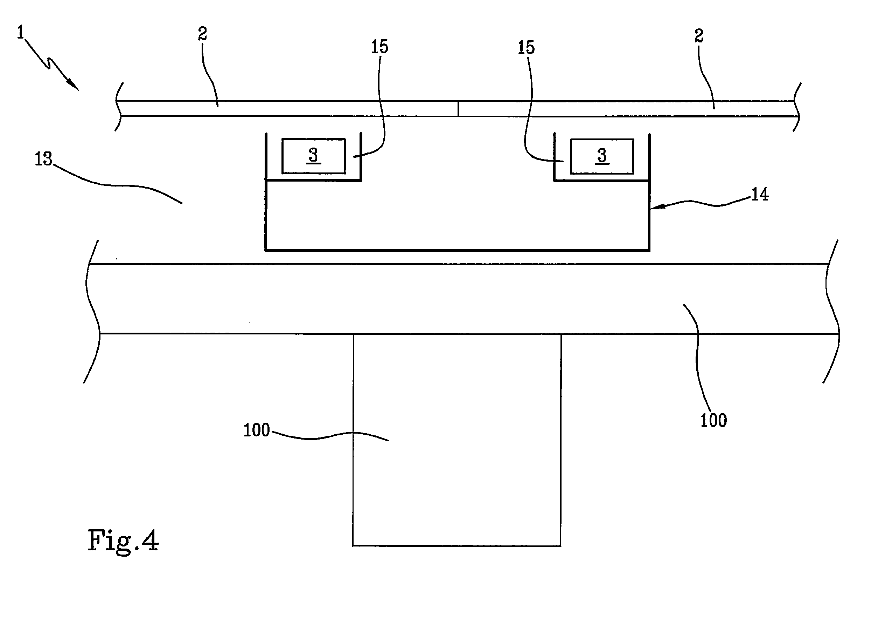

Advantageously, the junction boxes 3 are disposed under the photovoltaic panels 2 (therefore not directly exposed to the atmospheric agents that could cause shortcircuits) and within the overall sizes defined by the conveying drain 14 (see Fig. 4).

In addition, the junction boxes 3 are not directly in contact with the conveying drain 14, to prevent said junction boxes 3 from being flooded by the waste water carried by drain 14.

To this aim, drain 14 comprises at least one, preferably two, housing seats 15 extending along the whole length of drain 14 at a peripheral position relative to a cross-section of said drain (see Fig. 4). These housing seats 15 are fully contained within the overall dimensions defined by the photovoltaic panels 2.

The junction boxes 3 are contained within the housing seats 15, in such a manner that the junction boxes 3 are raised relative to the waters running in drain 14 and are at all events contained within an uninflammable structure (as above said, the drains are made of metal material). This ensures that also following starting of a fire within a junction box 3, the fire does not easily spread as it is confined within an environment in which the combustible material is almost absent.

In addition, the electric cables connecting the junction boxes 3 with the conversion board 4 are housed within the housing seats 14 of the drains, and therefore in environments that are not subject to flame propagation and out of possible contact with rain water.

The spacer elements 12 too are made of metal material. In particular, the spacer elements 12 not only keep the photovoltaic panels 2 to a raised position, but also retain the latter in place acting as connecting elements between panels 2 disposed in side by side relationship along a direction perpendicular to the approach line X.

The spacer elements 12 further allow the photovoltaic panels 2 to be connected to the roof tiles 101 (Fig. 3). Preferably, the spacer elements 12 are identical with each other.

## Claims

1. A photovoltaic coating including at least two photovoltaic panels (2) adjacent to each other and approached along an approach line (X), at least two junction boxes (3) operatively connected to said panels (2) and in electrical connection with a conversion board (4) adapted to put the electric energy produced by the panels (2) in the mains, spacer elements (2) acting between the photovoltaic panels (2) and the roof frame elements (100) of a coating for creating an air space for air recirculation (13) between the photovoltaic panels (2) and the roof frame elements (100), **characterised in that** it comprises at least one conveying drain (14) acting within said air space for air recirculation (13) and disposed under the approach line (X) of the panels for conveying the rain water to a gutter; a detecting device (5) for temperature detection and acting on a respective junction box (3) for generating a signal (ST) representative of the temperature in said junction box (3); a breaking device (7) acting in a junction box (3) for electrically insulating said junction box (3) from the conversion board (4) on receipt of a break signal (SI); a comparing device (6) for comparing said temperature signal (ST) with a threshold value (SV) and generating said break signal (SI) when the temperature signal (ST) exceeds the threshold value (SV).

2. A coating as claimed in claim 1, wherein said junction boxes (3) are disposed under said photovoltaic panels (2) within the overall dimensions defined by said conveying drain (14); said junction boxes (3) not being in direct contact with said conveying drain (14).

3. A coating as claimed in claim 1 or 2, wherein said breaking device (7) shortcircuits output terminals (3b) of the junction box (3) upon receipt of a break signal (SI) generated by the comparing device (6) when the temperature signal (ST) emitted by the detecting device (5) associated with the same junction box (3) exceeds a threshold value (SV).

4. A coating as claimed in claim 1 or 2, wherein said breaking device (7) shortcircuits output terminals (3b) of the junction box (3) on receipt of a break signal (SI) generated by the comparing device (6) when the temperature signal (ST) emitted from the detecting device (5) associated with anyone of the junction boxes (3) exceeds the threshold value (SV).

5. A coating as claimed in anyone of the preceding claims, wherein said breaking device (7) is a relay acting on output terminals (3b) of the junction box (3).

6. A coating as claimed in anyone of the preceding claims, wherein said comparing device (6) generates said break signal (SI) when a predetermined number of consecutive temperature signals (ST) emitted by the same detecting device (5) exceeds said threshold value (SV).

7. A coating as claimed in anyone of claims 1 to 5, wherein said comparing device (6) generates said break signal (SI) when all temperature signals (ST) sent from the same detecting device (5) in a time unit exceed said threshold value (SV).

8. A coating as claimed in anyone of the preceding claims, wherein said threshold signal (SV) is included between 90°C and 115°C, and is preferably equal to 105°C.

9. A coating as claimed in anyone of the preceding claims, wherein the comparing device (6) receives signals from the detecting devices (5) and sends signals to the breaking devices (7) through wireless technology.

10. A coating as claimed in anyone of the preceding claims, comprising a user-recognising unit (11) for recognising authorised users, said recognising unit (11) being configured for enabling an authorised user to generate break signals (SI) for said breaking devices (7) irrespective of receiving of temperature signals (ST) by said comparing device (6).

11. A coating as claimed in claim 10, wherein said recognising unit (11) generates a refit signal (SR) and sends it to one or more breaking devices (7) for refitting one or more junction boxes (3) that have received break signals (SI); said refit signal (SR) being generated by an authorised user.

12. A coating as claimed in anyone of claims 2 to 11, wherein said conveying drain (14) and spacer elements (12) are made of metal material.
